# EUROPEAN PATENT APPLICATION

(11) **EP 4 553 903 A1**
(43) Date of publication of application: **14.05.2025**
(21) Application number: 23835531.7
(22) Date of filing: 04.07.2023
(51) Int. Cl.: H01L 27/146, G02B 3/00, G02B 5/20, G02B 5/22, H04N 25/11

(54) **IMAGE SENSOR AND METHOD FOR MANUFACTURING SAME**

(30) Priority: 06.07.2022 JP 2022108968
(71) Applicant: Toppan Holdings Inc., Tokyo 110-0016 (JP)
(72) Inventor: SAKAGAWA, Makoto, Tokyo 110-0016 (JP)
(74) Representative: Hoffmann Eitle
(86) International application number: PCT/JP2023/024771
(87) International publication number: WO 2024/009999

(57) **Abstract**

Provided is a technique that makes it possible to improve the detection accuracy of an image sensor with respect to infrared radiation. An image sensor 1A includes: a substrate 2 on which a plurality of photodiodes are provided; a color filter 4 which is provided with a plurality of colored layers and has a plurality of first through-holes; an infrared-blocking layer 6 which is provided on the color filter, and has a plurality of second through-holes each communicating with the plurality of first through-holes; a plurality of infrared-transmissive layers 41, in each of which one of the plurality of first through-holes and the second through-hole communicating therewith are embedded; and a plurality of micro lenses 51. In the image sensor 1A, the side wall of each of the plurality of second through-holes is entirely in contact with the side surface of any one of the plurality of infrared-transmissive layers 41. The upper surface of the infrared-blocking layer has a maximum height H_{CH} at the position of the boundary with the plurality of infrared-transmissive layers 41, and has a minimum height H_{CL} at a position away from the boundary. The upper surface of each of the plurality of infrared-transmissive layers 41 has a maximum height H_{PH} that is greater than the minimum height H_{CL} and is greater than or equal to the maximum height H_{CH}.

## Description

### [Technical Field]

The present invention relates to an image sensor and a method for manufacturing the same.

### [Background Art]

Image sensors (or solid-state imaging elements) are provided with a substrate formed having a plurality of photodiodes, which convert light into an electrical signal having a magnitude corresponding to the intensity of light. An example of an image sensor is an image sensor provided with a color filter positioned on photodiodes for each color, an infrared-transmissive layer positioned on photodiodes for infrared radiation, and an infrared-blocking layer provided on the color filter (for example, see PTL 1).

The image sensor described in PTL 1 has a structure in which an upper surface of the infrared-transmissive layer is lower than an upper surface of the infrared-blocking layer. In the same literature, the image sensor having the structure above is manufactured by forming the color filter on the photodiodes for each color, which are formed on the substrate, forming the infrared-blocking layer as an upper layer thereof, and then forming the infrared-transmissive layer so as to fill concave portions that are at the positions of the photodiodes for infrared radiation on the substrate.

### [Citation List]

### [Patent Literature]

PTL 1: JP 6317695 B

### [Summary of the Invention]

The present invention has an object of providing a technique that makes it possible to improve the detection accuracy of an image sensor with respect to infrared radiation.

According to an aspect of the present invention, provided is an image sensor including:
a substrate on which a plurality of photodiodes are provided;
a color filter including a plurality of colored layers which are each provided on a portion of the plurality of photodiodes, and a plurality of first through-holes which are each provided in a position of another portion of the plurality of photodiodes;
an infrared-blocking layer which is provided on the color filter, blocks infrared radiation having a specific wavelength, and transmits visible light, and has a plurality of second through-holes each communicating with the plurality of first through-holes;
a plurality of infrared-transmissive layers, in each of which one of the plurality of first through-holes and the second through-hole communicating therewith are embedded, and which block visible light and transmit the infrared radiation having the specific wavelength; and
a plurality of micro lenses each facing the plurality of photodiodes and having the color filter, the infrared-blocking layer, and the plurality of infrared-transmissive layers interposed therebetween; wherein
a side wall of each of the plurality of second through-holes is entirely in contact with a side surface of any one of the plurality of infrared-transmissive layers;
an upper surface of the infrared-blocking layer has a maximum height H_{CH} at a position of a boundary with the plurality of infrared-transmissive layers, and has a minimum height H_{CL} at a position away from the boundary, and
an upper surface of each of the plurality of infrared-transmissive layers has a maximum height H_{PH} that is greater than the minimum height HCL and is greater than or equal to the maximum height H_{CH}.

According to another aspect of the present invention, provided is the image sensor according to the aspect above, wherein
the upper surface of each of the plurality of infrared-transmissive layers has a convex shape.

According to yet another aspect of the present invention, provided is an image sensor according to any one of the aspects above, wherein
of the upper surface of the infrared-blocking layer, a plurality of first regions that are each adjacent to the plurality of second through-holes have a height that is greater than that of second regions, which are each adjacent to the plurality of second through-holes and have the plurality of first regions interposed therebetween.

According to yet another aspect of the present invention, provided is an image sensor according to any one of the aspects above, wherein
one or more of the plurality of colored layers that are in contact with the plurality of infrared-transmissive layers has a reverse tapered cross-sectional shape.

According to yet another aspect of the present invention, provided is a method for manufacturing an image sensor, the method including:
forming a color filter including a plurality of colored layers and having a plurality of through-holes, such that each of the plurality of colored layers is provided on a portion of a plurality of photodiodes that are provided on a substrate, and the plurality of through-holes are provided in a position of another portion of the photodiodes;
forming a plurality of infrared-transmissive layers that block visible light and transmit infrared radiation having a specific wavelength, each having one of the plurality through-holes embedded therein, and formed protruding from the plurality of through-holes;
forming, on the color filter, an infrared-blocking layer that blocks infrared radiation having the specific wavelength, and transmits visible light, such that an upper surface of the infrared-blocking layer has a height that is less than that of the plurality of infrared-transmissive layers;
subjecting the infrared-blocking layer to a heat flow; and
forming thereafter a plurality of micro lenses each facing the plurality of photodiodes and having the color filter, the infrared-blocking layer, and the plurality of infrared-transmissive layers interposed therebetween.

According to the present invention, a technique is provided that makes it possible to improve the detection accuracy of an image sensor with respect to infrared radiation.

### [Brief Description of the Drawings]

Fig. 1 is a perspective view showing a portion of an image sensor according to an embodiment of the present invention.
Fig. 2 is a cross-sectional view along line II-II of the image sensor shown in Fig. 1.
Fig. 3 is a cross-sectional view showing a step in an example of a manufacturing method of the image sensor shown in Figs. 1 and 2.
Fig. 4 is a cross-sectional view showing another step in an example of a manufacturing method of the image sensor shown in Figs. 1 and 2.
Fig. 5 is a cross-sectional view showing yet another step in an example of a manufacturing method of the image sensor shown in Figs. 1 and 2.
Fig. 6 is a cross-sectional view showing yet another step in an example of a manufacturing method of the image sensor shown in Figs. 1 and 2.
Fig. 7 is a cross-sectional view showing a portion of an image sensor according to a modification of an embodiment of the present invention.
Fig. 8 is a cross-sectional view showing a portion of an image sensor according to a comparative example.
Fig. 9 is a cross-sectional view showing a portion of an image sensor according to another comparative example.
Fig. 10 is a cross-sectional view showing a portion of an image sensor according to yet another comparative example.
Fig. 11 is a microscope image of an infrared-blocking layer that has been captured from an oblique direction before a heat flow is applied in Example 1.
Fig. 12 is a microscope image of an infrared-blocking layer that has been captured from an oblique direction after a heat flow is applied in Example 1.
Fig. 13 is a microscope image of a cross-section of the infrared-blocking layer of Fig. 12.
Fig. 14 is a microscope image of an infrared-blocking layer that has been captured from an oblique direction before a heat flow is applied in Comparative Example 1.
Fig. 15 is a microscope image of an infrared-blocking layer that has been captured from an oblique direction after a heat flow is applied in Comparative Example 1.
Fig. 16 is a microscope image of a cross-section of the infrared-blocking layer of Fig. 15.

### [Description of the Embodiments]

Hereinafter, embodiments of the present invention will be described with reference to the drawings. The embodiments described below are more specific implementations of the aspects above. The subject matter described below can be incorporated into each of the aspects described above, either alone or in combination.

Furthermore, the embodiments described below are merely examples of configurations for specifically implementing the technical ideas of the present invention, and the technical ideas of the present invention are not limited to the materials, shapes, and structures of the components described below. Various modifications can be made to the technical ideas of the present invention within a technical scope defined by the claims.

It should be noted that components having equivalent or similar functions are designated with like reference signs in the drawings referenced below, and duplicate explanations are omitted. In addition, the drawings are schematic, and the relationship between the dimensions in one direction and the dimensions in another direction, the relationship between the dimensions of one member and the dimensions other members, and the like, may differ from the actual relationships.

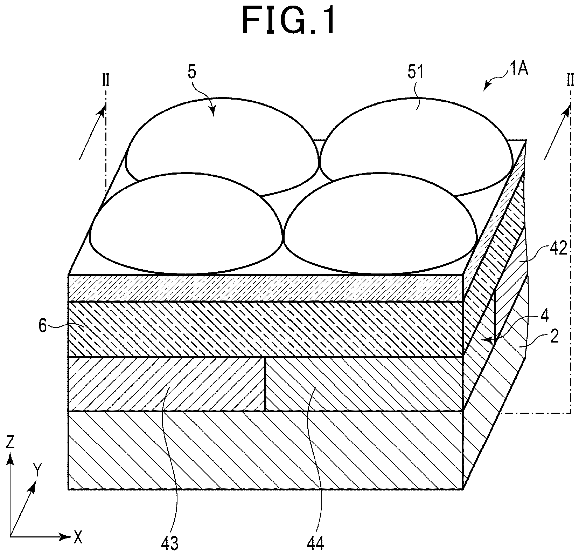

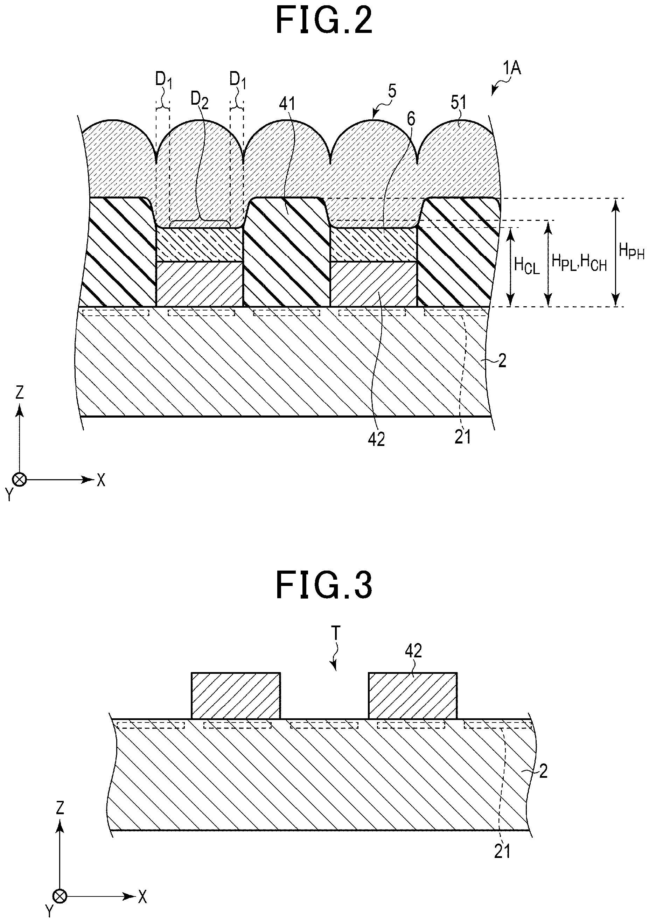

Fig. 1 is a perspective view showing a portion of an image sensor according to an embodiment of the present invention. Fig. 2 is a cross-sectional view along line II-II of the image sensor shown in Fig. 1.

The image sensor 1A shown in Figs. 1 and 2 is, for example, a complementary metal oxide semiconductor (CMOS) image sensor or a charge-coupled device (CCD) image sensor. The image sensor 1A includes a substrate 2, a color filter 4 including first colored layers 42, second colored layers 43, and third colored layers 44, a micro lens array 5, an infrared-blocking layer 6, and infrared-transmissive layers 41.

Note that, in each of the drawings, the X direction is a direction parallel to the main surface of the substrate 2 facing the micro lens array 5. The Y direction is a direction parallel to the main surface, and intersects the X direction. The Z direction is a direction perpendicular to the X direction and Y direction, that is, the thickness direction of the substrate 2. Here, as an example, it is assumed that the X direction and the Y direction are perpendicular to each other.

### <Substrate>

The substrate 2 is a semiconductor substrate such as a silicon substrate. As shown in Fig. 2, a plurality of photodiodes 21, which are photoelectric conversion elements, are provided on a surface region of the substrate 2. The plurality of photodiodes 21 include photodiodes for each color facing each of the first colored layers 42, the second colored layers 43, and the third colored layers 44, and photodiodes for infrared radiation facing the infrared-transmissive layers 41. The photodiodes for each color measure the intensity of visible light having a specific wavelength. The photodiodes for infrared radiation measure the intensity of infrared radiation. The photodiodes 21 are arranged in the X direction and Y direction.

The image sensor 1A may further include a flattening layer on the main surface of the substrate 2 on the photodiode 21 side in order to improve adhesion.

### <Color Filter>

The color filter 4 includes a plurality of colored layers having different transmission spectra. Here, the color filter 4 includes the first colored layers 42, the second colored layers 43, and the third colored layers 44. The number of types of colored layers included in the color filter 4 does not have to be three, as long as two or more types are included.

The first colored layers 42, the second colored layers 43, and the third colored layers 44 have different transmission spectra. The first colored layers 42, the second colored layers 43, and the third colored layers 44 are respectively, for example, a red layer, a blue layer, a green layer, a yellow layer, a magenta layer, or a cyan layer. As an example, the first colored layers 42, the second colored layers 43, and the third colored layers 44 are a red layer, a blue layer, and a green layer. As another example, the first colored layers 42, the second colored layers 43, and the third colored layers 44 are a yellow layer, a magenta layer and a cyan layer.

The color filter 4 has a plurality of first through-holes. As shown in Fig. 2, the first through-holes are embedded in the infrared-transmissive layers 41.

In the color filter 4, the first through-holes and the first colored layers 42 each extend in the X direction, and form a plurality of first rows that are arranged in the Y direction. In each of the first rows, the first through-holes and the first colored layers 42 are alternately arranged in the X direction. The second colored layers 43 and the third colored layers 44 each extend in the X direction, and form a plurality of second rows that are arranged in the Y direction. In each of the second rows, the second colored layers 43 and the third colored layers 44 are alternately arranged in the X direction. Further, the first rows and the second rows are alternately arranged in the Y direction.

As described above, the first colored layers 42, the second colored layers 43, and the third colored layers 44 are each provided facing the photodiodes for each color among the plurality of photodiodes 21, and the plurality of first through-holes are provided facing the photodiodes for infrared radiation among the plurality of photodiodes 21.

The color filter 4 is formed, for example, by patterning a photosensitive material containing a colorant by photolithography.

The film thickness of each colored layer included in the color filter 4 may be different from each other, or may be the same. The film thickness of each colored layer may be, for example, in a range of 0.3 µm to 1.0 µm, or may be in a range of 0.4 to 0.7 µm.

### <Infrared-Blocking Layer>

The infrared-blocking layer 6 is provided on the color filter 4, and is a layer that blocks infrared radiation having a specific wavelength, and transmits visible light. The infrared-blocking layer 6 blocks infrared radiation of a wavelength band that can be detected as noise by the photodiodes 21 facing the color filter 4. As a result, the detection accuracy of the photodiodes 21 can be enhanced.

The infrared-blocking layer 6 is provided on the color filter 4, and has a plurality of second through-holes that communicate with each of the plurality of first through-holes contained in the color filter 4. As shown in Fig. 2, the second through-holes are embedded in the infrared-transmissive layers 41.

The infrared-blocking layer 6 contains, for example, an infrared absorbing colorant and a transparent resin. The infrared absorbing colorant is, for example, a dye such as a squarylium dye, a croconium dye, a diimmonium dye, an anthraquinone dye, a cyanine dye, a phthalocyanine dye, or a dithiol dye. The transparent resin is, for example, an acrylic resin, a polyamide resin, a polyimide resin, a polyurethane resin, a polyester resin, a polyether resin, a polyolefin resin, a polycarbonate resin, a polystyrene resin, a norbornene resin, and the like.

The infrared-blocking layer 6 can be formed by a photolithography method using a photosensitive material containing, for example, an infrared absorbing colorant, a polymerizable compound, a binder resin, and a photopolymerization initiator. The photosensitive material may contain additives for providing other functions, such as a light stabilizer, an antioxidant, a heat stabilizer, and an antistatic agent.

The film thickness of the infrared-blocking layer 6 may be, for example, in a range of 0.5 µm to 1.2 µm, or may be in a range of 0.7 to 1.0 µm.

### <Infrared-Transmissive Layer>

The infrared-transmissive layers 41 are optical filters that block visible light, and transmit infrared radiation of a specific wavelength. That is, the infrared-transmissive layers 41 transmit infrared radiation that can be detected by the photodiodes 21 (the photodiodes for infrared radiation mentioned above), and block visible light that can be detected by the photodiodes 21. The detection accuracy of infrared radiation by the photodiodes 21 can be enhanced by the infrared-transmissive layers 41. The infrared radiation of a specific wavelength that can be detected by the photodiodes 21 is, for example, near-infrared radiation having a wavelength in a range of 900 nm or more and 1,100 nm or less.

The infrared-transmissive layers 41 are provided on the substrate 2, in each of which one of the plurality of first through-holes provided in the color filter 4 and the second through-hole provided in the infrared-blocking layer 6 communicating therewith are embedded. Here, the infrared-transmissive layers 41 are arranged in the X direction and Y direction. Each of the infrared-transmissive layers 41 has a first through-hole and a second through-hole communicating therewith embedded therein, and is formed upwardly protruding from the upper surface of the color filter 4.

The infrared-transmissive layers 41 contain, for example, an infrared radiation transmissive colorant. The infrared radiation transmissive colorant preferably transmits at least a portion of the light, particularly in a near-infrared region, and is a material that blocks light in the visible region. The infrared-transmissive layer 41 may contain two or more types of chromatic colorants as the infrared radiation transmissive colorant, and may exhibit a black color using the combination of the two or more types of chromatic colorants. Alternatively, the infrared-transmissive layer 41 may contain an organic black colorant as the infrared radiation transmissive colorant.

The chromatic colorant may be a pigment or a dye, but is preferably a pigment, and more preferably an organic pigment. The infrared-transmissive layers 41 may, for example, contain two or more types of chromatic colorants selected from among red colorants, green colorants, blue colorants, yellow colorants, purple colorants, and orange colorants.

The infrared-transmissive layers 41 may contain inorganic oxide particles for adjusting the refractive index. Examples of the inorganic oxide include aluminum oxide, silicon oxide, zirconium oxide, and titanium oxide. Furthermore, the infrared-transmissive layers 41 may contain additives for providing other functions, such as a light stabilizer, an antioxidant, a heat stabilizer, and an antistatic agent.

The infrared-transmissive layers 41 can be formed by a photolithography method using a photosensitive material containing, for example, an infrared radiation transmissive colorant, a polymerizable compound, a binder resin, a photopolymerization initiator, and the like.

The film thickness of the infrared-transmissive layers 41 may be, for example, in a range of 0.9 µm to 2.3 µm, or may be in a range of 1.2 to 1.8 µm.

### <Micro Lens Array>

The micro lens array 5 is provided facing the substrate 2, with the color filter 4, the infrared-blocking layer 6, and the infrared-transmissive layers 41 interposed therebetween. The micro lens array 5 is composed of a colorless and transparent organic material, such as a polymer.

The micro lens array 5 includes a plurality of micro lenses 51. The micro lenses 51 face the photodiodes 21, with the color filter 4, the infrared-blocking layer 6, and the infrared-transmissive layers 41 interposed therebetween.

Each of the micro lenses 51 are convex lenses whose upper surface is a convex surface. Here, an orthogonal projection of each of the micro lenses 51 onto a plane perpendicular to the Z direction is a circle. The orthogonal projection may have another shape, such as a square with rounded corners. Each of the micro lenses 51 may have a substantially hemispherical upper portion and a substantially rectangular prism-shaped lower portion.

The image sensor 1A includes a plurality of pixels arranged in the X direction and Y direction. Here, the pixels include first to fourth subpixels. The first subpixels include an infrared-transmissive layer 41, and a photodiode 21 and micro lens 51 facing the same. The second subpixels include a first colored layer 42, and a photodiode 21 and micro lens 51 facing the same. The third subpixels include a second colored layer 43, and a photodiode 21 and micro lens 51 facing the same. The fourth subpixels include a third colored layer 44, and a photodiode 21 and micro lens 51 facing the same.

In the image sensor 1A, the upper surface of the infrared-transmissive layers 41 is located in a position that is higher than the upper surface of the infrared-blocking layer 6. Here, "the upper **surface** of the infrared-transmissive layers 41 is located in a position that is higher than the upper surface of the infrared-blocking layer 6" means the following. That is, the upper surface of the infrared-blocking layer 6 has a maximum height H_{CH} at the position of the boundary with the plurality of infrared-transmissive layers 41, and has a minimum height H_{CL} at a position away from the boundary. Further, this means that the upper surface of each of the plurality of infrared-transmissive layers 41 has a maximum height H_{PH} that is greater than the minimum height H_{CL} of the upper surface of the infrared-blocking layer 6 (H_{CL} < H_{PH}), and is greater than or equal to the maximum height H_{CH} of the infrared-blocking layer 6 (H_{CH} ≦ H_{PH}). Here, the maximum height H_{CH} and minimum height H_{CL} of the upper surface of the infrared-blocking layer 6 only need to satisfy the relationship H_{CL} ≦ H_{CH}.

The image sensor 1A shown in Fig. 2 is an example of a mode in which the maximum height H_{PH} of the upper surface of the infrared-transmissive layers 41 is greater than the maximum height H_{CH} of the upper surface of the infrared-blocking layer 6, that is, a mode having the relationship H_{PH} > H_{CH}. When the minimum height of the upper surface of the infrared-transmissive layers 41 is HPL, in the image sensor 1A having the relationship H_{PH} > H_{CH}, the minimum height H_{PL} of the upper surface of the infrared-transmissive layers 41 is, as shown in Fig. 2, less than the maximum height H_{PH} (H_{PL} < H_{PH}), and equal to the maximum height H_{CH} of the upper surface of the infrared-blocking layer 6 (H_{PL} = H_{CH}). In this case, the upper surface of the infrared-transmissive layers 41 has a convex shape, and consists of a region that has the maximum height H_{PH}, and a region that is adjacent to this region whose height changes from the maximum height H_{PH} to the minimum height H_{PL}. Note that the relationship H_{PH} > H_{CL} is necessarily satisfied.

In the image sensor 1A shown in Fig. 2, the upper surface of the infrared-blocking layer 6 has a structure in which the section that makes contact with the side surface of the infrared-transmissive layers 41 (a first region D₁ described below) rises toward the infrared-transmissive layers 41 (H_{CL} < H_{CH}). However, in the image sensor 1A, as shown in Fig. 2, when the upper surface of the infrared-transmissive layers 41 has the relationship H_{PH} > H_{CH} with respect to the upper surface of the infrared-blocking layer 41, and has a convex shape, the upper surface of the infrared-blocking layer 6 is not limited to the mode shown in Fig. 2. That is, when the upper surface of the infrared-transmissive layers 41 has a convex shape satisfying the relationship H_{PH} > H_{CH}, the maximum height H_{CH} and minimum height H_{CL} of the upper surface of the infrared-blocking layer 6 may have the relationship H_{CL} < H_{CH} shown in Fig. 2, or may have the relationship H_{CL} = _{CH}. In the case of the latter relationship where H_{CL} = _{CH}, although not illustrated, the upper surface of the infrared-blocking layer 6 is flat.

Furthermore, although not illustrated, in the image sensor 1A, the maximum height H_{PH} of the upper surface of the infrared-transmissive layers 41 may be equal to the maximum height H_{CH} of the upper surface of the infrared-blocking layer 6 (H_{PH} = H_{CH}). However, because satisfying the relationship H_{PH} > H_{CL} mentioned above becomes a condition, the maximum height H_{CH} and minimum height H_{CL} of the upper surface of the infrared-blocking layer 6 are required to have the relationship H_{CL} < H_{CH}. That is, in the image sensor 1A having the relationship H_{PH} = H_{CH}, the upper surface of the infrared-blocking layer 6 has, in the same manner as in Fig. 2, a structure in which the sections that make contact with the side surface of the infrared-transmissive layers 41 (a first region D₁) rises toward the infrared-transmissive layers 41. In this case, the upper surface of the infrared-transmissive layers 41 is a region having the maximum height H_{PH}, and is flat (H_{PH} = HPL).

In the image sensor 1A, the side wall of each of the plurality of second through-holes provided in the infrared-blocking layer 6 is entirely in contact with the side surface of any one of the plurality of infrared-transmissive layers 41. That is, in the image sensor 1A, the side wall of the infrared-blocking layer 6 is entirely in contact with the infrared-transmissive layers 41, and there is no gap between the infrared-transmissive layers 41 and the infrared-blocking layer 6.

In the method for manufacturing the image sensor 1A, as described below, the infrared-blocking layer 6 is formed after forming the color filter 4 and the infrared-transmissive layers 41. The infrared-blocking layer 6 is formed by patterning on the color filter 4 such that the upper surface has a height that is less than the upper surface of the infrared-transmissive layers 41, and then applying a heat flow. In this case, because the upper surface of the infrared-transmissive layers 41 is at a higher position than the upper surface of the infrared-blocking layer 6, it is possible to suppress the occurrence of color mixing between the infrared-blocking layer 6 and the infrared-transmissive layers 41 as a result of subjecting the infrared-blocking layer 6 to a heat flow. Note that the occurrence of color mixing when the upper surface of the infrared-transmissive layers 41 is at a lower position than the upper surface of the infrared-blocking layer 6 will be described using a comparative example.

In the image sensor 1A, the difference H_{D} between the height of the upper surface of the infrared-transmissive layers 41 and the upper surface of the infrared-blocking layer 6 is 0 < H_{D}, is preferably 0.05 µm ≦ H_{D}, and more preferably 0.1 µm ≦ H_{D}. Here, the difference H_{D} in the height of the upper surfaces represents the difference between the maximum height H_{PH} of the upper surface of the infrared-transmissive layers 41 and the minimum height H_{CL} of the infrared-blocking layer 6 (H_{D} = H_{PH} - H_{CL}). On the other hand, when the difference H_{D} in the height of the upper surfaces becomes large, there is a tendency for uneven coating to occur when forming the infrared-blocking layer 6, and further, when the film thickness of the infrared-transmissive layers 41 becomes large, there is also a tendency for the infrared-transmissive layers 41 to become difficult to form. From this viewpoint, it is preferable that the difference H_{D} in the height of the upper surfaces is H_{D} ≦ 1.0 µm, is more preferably H_{D} ≦ 0.8 µm, and even more preferably H_{D} ≦ 0.3 µm.

As a result of subjecting the infrared-blocking layer 6 to a heat flow, as mentioned above, it is possible to cause the side wall of the infrared-blocking layer 6 to be entirely in contact with the side surface of the infrared-transmissive layers 41, and it becomes possible to prevent a gap from forming between the infrared-transmissive layers 41 and the infrared-blocking layer 6. This makes it possible to suppress the occurrence of stray light, and to reduce noise. The effect described above of subjecting the infrared-blocking layer 6 to a heat flow is more easily obtained when the infrared-blocking layer 6 contains a dye as the infrared absorbing colorant rather than a pigment.

In the image sensor 1A shown in Fig. 2, the upper surface of each of the plurality of infrared-transmissive layers 41 has a convex shape. In this case, a lens effect occurs with respect to the light collection by the micro lenses 51 facing the infrared-transmissive layers 41, and the detection accuracy of infrared radiation improves.

In the image sensor shown in Fig. 2, of the upper surface of the infrared-blocking layer 6, a plurality of first regions D₁ that are each adjacent to the plurality of second through-holes have a height that is greater than that of second regions D₂, which are each adjacent to the plurality of second through-holes and have the plurality of first regions interposed therebetween. Here, of the upper surface of the infrared-blocking layer 6, the sections that make contact with the side surface of the infrared-transmissive layers 41 rise toward the infrared-transmissive layers 41. When a valley portion is formed between the side surface of the infrared-blocking layer 6 and the side surface of the infrared-transmissive layers 41, defects such as voids (gaps) are more likely to occur when the micro lens array 5 is formed. As described above, in the image sensor 1A, because the height of the first region D₁ of the upper surface of the infrared-blocking layer 6 is greater than that of the second region D₂, the occurrence of defects such as voids (gaps) is suppressed.

In the infrared-blocking layer 6, when a dye is used as the infrared absorbing colorant rather than a pigment, the section of the upper surface of the infrared-blocking layer 6 that makes contact with the side surface of the infrared-transmissive layers 41 more easily forms a structure that rises toward the infrared-transmissive layers 41. As a result, the effect of suppressing voids caused by subjecting the infrared-blocking layer 6 to a heat flow is improved when the infrared-blocking layer 6 contains a dye as the infrared absorbing colorant rather than a pigment.

The image sensor 1A can be manufactured, for example, according to the following method. Figs. 3 to 6 are cross-sectional views showing the steps of an example of a manufacturing method for the image sensor 1A shown in Figs. 1 and 2.

In this method, first, the color filter 4 is formed on the substrate 2.

As described above, the color filter 4 includes the first colored layers 42, the second colored layers 43, and the third colored layers 44, and the plurality of first through-holes. As shown in Fig. 3, each of the first through-holes T are positioned between the first colored layers 42 that are adjacent to each other in the X direction. Furthermore, each of the first through-holes T are positioned between the second colored layers 43 that are adjacent to each other in the Y direction.

The first colored layers 42 are formed by forming a coating film composed of a photosensitive material containing a colorant on the substrate 2, and then patterning the coating film using a photographic method including exposure, development, and sintering. The second colored layers 43 and the third colored layers 44 are formed by the same method as the first colored layers 42. The order in which the first colored layers 42, the second colored layer 43, and the third colored layers 44 are formed is arbitrary.

The patterning of the first colored layers 42, the second colored layers 43, and the third colored layers 44 is performed such that a plurality of first rows formed by alternately arranging the first through-holes T and the first colored layers 42 in the X direction, and a plurality of second rows formed by alternately arranging the second colored layers 43 and the third colored layers 44 in the X direction, are alternately arranged in the Y direction.

As the colorant contained in the first colored layers 42, the second colored layers 43, and the third colored layers 44, an organic or inorganic pigment can be singly used or as a mixture of two or more types. The pigment has high color development and high heat resistance, and in particular, is preferably a pigment having high resistance to thermal decomposition, and an organic pigment is normally used. Examples of pigments that can be used include organic pigments such as phthalocyanine-based, azo-based, anthraquinone-based, quinacridone-based, dioxazine-based, anthanthrone-based, indanthrone-based, perylene-based, thioindigo-based, isoindoline-based, quinophthalone-based, and diketopyrrolopyrrole-based organic pigments.

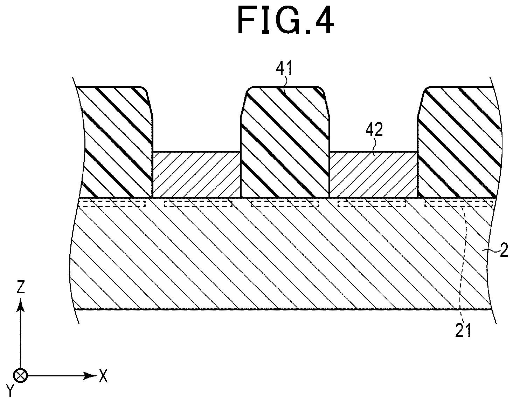

Next, as shown in Fig. 4, the infrared-transmissive layers 41 are formed on the substrate 2.

In Fig. 4, the infrared-transmissive layers 41 are formed in the positions of the first through-holes T shown in Fig. 3, and the infrared-transmissive layers 41 and the first colored layers 42 are alternately arranged.

The infrared-transmissive layers 41 are formed using a photosensitive material containing an infrared radiation transmissive colorant, and by pattering the photosensitive material using a photolithography method including exposure, development, and sintering, each having one of the plurality of first through-holes T is embedded therein, and formed protruding from the plurality of first through-holes T.

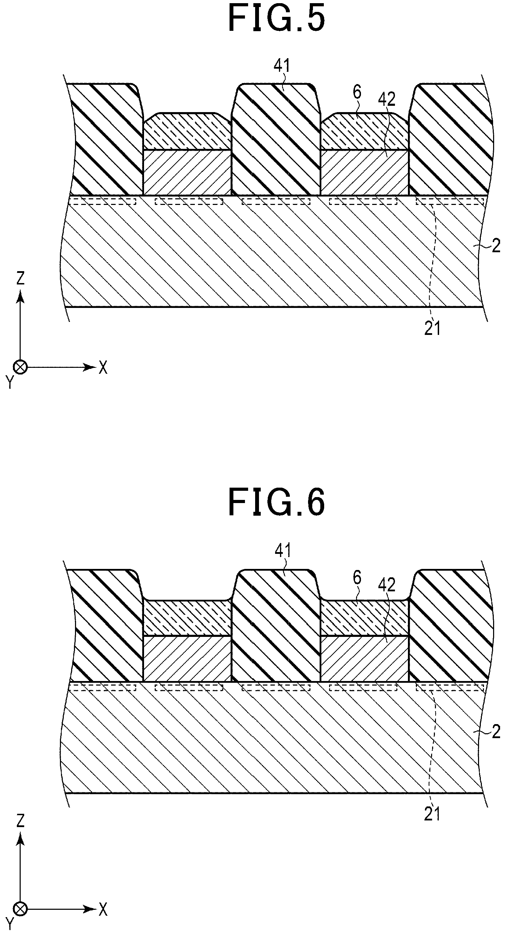

Next, the infrared-blocking layer 6 is formed on the color filter 4, and this is subjected to a heat flow. Figs. 5 and 6 show cross-sectional views of a step in which the infrared-blocking layer 6 is formed on the first colored layers 42 contained in the color filter 4. Fig. 5 is a cross-sectional view of the step before subjecting the infrared-blocking layer 6 to a heat flow, and Fig. 6 is a cross-sectional view of the step after subjecting the infrared-blocking layer 6 to a heat flow.

As shown in Fig. 5, first, the infrared-blocking layer 6 is formed on the color filter 4 using a photosensitive material containing an infrared absorbing colorant such that the height of the upper surface is less than the upper surface of the infrared-transmissive layers 41. The infrared-blocking layer 6 is formed by a photolithography method including exposure and development.

As shown in Fig. 5, prior to subjecting the infrared-blocking layer 6 to a heat flow by sintering, the infrared-blocking layer 6 has at least a portion of the side surface (side wall of the second through-hole) that is not in contact with the side surface of the infrared-transmissive layers 41, and groove-shaped gaps are formed with the infrared-transmissive layers 41. As shown in Fig. 6, as a result of subjecting the infrared-blocking layer 6 to a heat flow, a structure is obtained in which the entire side surface of the infrared-blocking layer 6 makes contact with the side surface of the infrared-transmissive layers 41, and the groove-shaped gaps that had formed between the infrared-blocking layer 6 and the infrared-transmissive layers 41 disappear. Furthermore, as an example, as a result of the heat flow, a structure is obtained in which the section of the upper surface of the infrared-blocking layer 6 that makes contact with the side surface of the infrared-transmissive layers 41 rises toward the infrared-transmissive layers 41.

Next, the image sensor 1A shown in Figs. 1 and 2 is obtained by forming the micro lens array 5 containing the plurality of micro lenses 51.

The micro lenses 51 are each formed facing the plurality of photodiodes 21, with the color filter 4, the infrared-blocking layer 6, and the infrared-transmissive layer 6 interposed therebetween. The micro lenses 51 are formed, for example, using an etch-back method. In the etch-back method, first, a transparent resin layer for forming the micro lenses 51 is formed facing the substrate 2, with the color filter 4, the infrared-blocking layer 6, and the infrared-transmissive layer 6 interposed therebetween. Then, a resist pattern having a shape in which a plurality of hemispheres (lens shapes) are arranged is formed on the transparent resin layer. Further, the transparent resin layer provided with the resist pattern is dry-etched to transfer the shape of the resist pattern (lens shapes) to the transparent resin layer, which forms the plurality of micro lenses 51.

The transparent resin used to form the micro lenses 51 is, for example, an acrylic resin, a polyamide resin, a polyimide resin, a polyurethane resin, a polyester resin, a polyether resin, a polyolefin resin, a polycarbonate resin, a polystyrene resin, or a norbornene resin.

The micro lenses 51 can be formed without using an etching mask. That is, first, a coating film composed of a photosensitive material is formed facing the substrate 2, with the color filter 4, the infrared-blocking layer 6, and the infrared-transmissive layer 6 interposed therebetween. Then, the coating film is patterned by a photolithography method including exposure and development to form the plurality of micro lenses 51 composed of a cured photosensitive material, each facing the photodiode 21 with the color separation filter 4 interposed therebetween. Note that the patterning preferably further includes applying a heat flow by heating after the development.

In this way, the image sensor 1A shown in Figs. 1 and 2 is obtained.

The image sensor 1A obtained by such a method has superior detection accuracy with respect to infrared radiation. This will be described below referring to a comparative example.

As described above, in the method for manufacturing the image sensor 1A described with reference to Figs. 3 to 6, the infrared-blocking layer 6 is formed after forming the infrared-transmissive layers 41 such that the upper surface has a height that is less than that of the infrared-transmissive layers 41, and is subjected to a heat flow. Because the upper surface of the infrared-transmissive layers 41 is at a higher position than the upper surface of the infrared-blocking layer 6, the upper surface of the infrared-transmissive layers 41 does not become partially covered by the infrared-blocking layer 6, and therefore, the color mixing caused as a result of this can be suppressed.

Further, as described above, by forming the infrared-blocking layer 6 after forming the infrared-transmissive layer 6 and embedding the concave portions, it is possible to cause the side surface of the infrared-blocking layer 6 to be entirely in contact with the side surface of the infrared-transmissive layers 41, and it is possible to suppress the occurrence of groove-shaped gaps. Because the groove-shaped gaps are not formed, the generation of stray light caused by the small thickness of the infrared-blocking layer 6 in such positions is suppressed, and noise can be reduced.

In addition, as a result of subjecting the infrared-blocking layer 6 to a heat flow, it is not only possible to prevent gaps from forming between the infrared-transmissive layers 41 and the infrared-blocking layer 6, but as mentioned above, it is possible to obtain a structure in which the section of the upper surface of the infrared-blocking layer 6 that makes contact with the side surface of the infrared-transmissive layers 41 rises toward the infrared-transmissive layers 41. In this case, the occurrence of voids (gaps) can be suppressed.

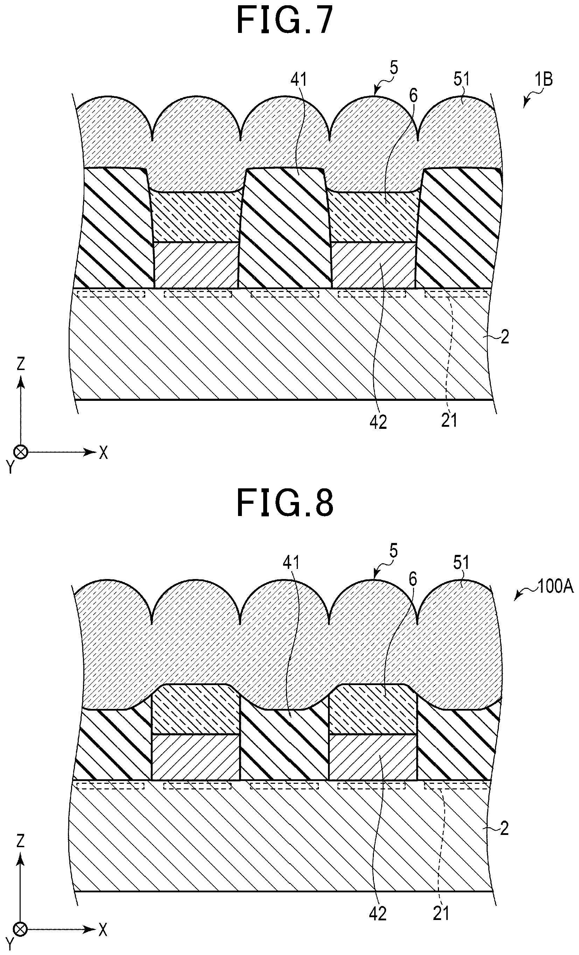

Fig. 8 is a cross-sectional view showing a portion of an image sensor according to a comparative example. In the image sensor 100A shown in Fig. 8, the upper surface of the infrared-transmissive layers 41 is located in a position that is lower than the upper surface of the infrared-blocking layer 6, and has a concave surface shape.

The image sensor 100A is manufactured by a method that includes a step of forming the color filter 4 including the second colored layers 42 on the substrate 2, a step of forming the infrared-blocking layer 6 on the color filter 4, and a step of forming the infrared-transmissive layers 41, in this order. In this sequence of steps, the infrared-transmissive layers 41 are formed filling the first through-holes and the second through-holes provided in each of the color filter 4 and the infrared-blocking layer 6 by being spin coated on the substrate 2 such that the height of the upper surface is less than the upper surface of the infrared-blocking layer 6, and is formed by a photolithography method. In this case, the upper surface of the infrared-transmissive layers 41 tends to have a concave surface shape as shown in Fig. 8.

When the upper surface of the infrared-transmissive layers 41 has a concave surface shape as in the image sensor 100A, the light collecting effect by the micro lenses 51 facing the upper surface is reduced, and the detection accuracy of infrared radiation decreases.

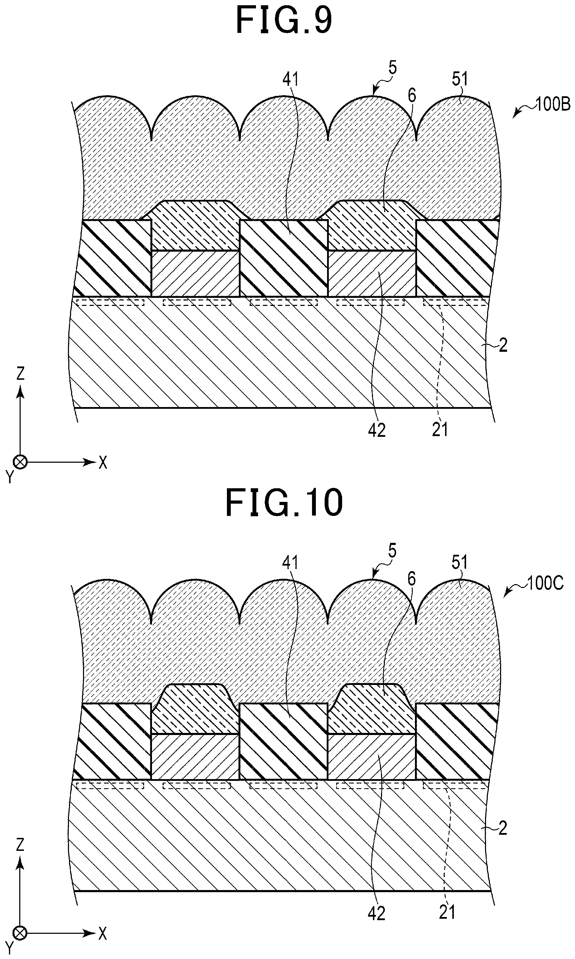

Figs. 9 and 10 are each a cross-sectional view showing a portion of image sensors according to other comparative examples. The image sensor 100B shown in Fig. 9, and the image sensor 100C shown in Fig. 10 each have the upper surface of the infrared-transmissive layers 41 at a lower position than the upper surface of the infrared-blocking layer 6, and the side surface of the infrared-blocking layer 6 has a tapered shape.

In contrast to the method for manufacturing the image sensor 100A described above, the image sensors 100B and 100C are manufactured by switching the order of the step of forming the infrared-blocking layer 6 and the step of forming the infrared-transmissive layers 41. That is, the image sensors 100B and 100C are manufactured by a method that includes a step of forming the color filter 4 including the first colored layers 42, a step of forming the infrared-transmissive layers 41, and a step of forming the infrared-blocking layer 6, in this order.

In this sequence of steps, the infrared-blocking layer 6 is formed as a result of a photosensitive material containing an infrared absorbing colorant being coated on the upper surface of the infrared-transmissive layers 41 and the upper surface of the color filter 4, and then being patterned on the color filter 4 by a photolithography method including exposure, development, and sintering. In the infrared-blocking layer 6, the dye-based colorant mentioned above is often used as the infrared absorbing colorant. The photosensitive material containing the dye-based colorant results in the side surface more easily forming a tapered shape when subjected to a heat flow during sintering compared to a photosensitive material containing a pigment.

In the image sensor 100B shown in Fig. 9, as a result of the side surface of the infrared-blocking layer 6 having a tapered shape, color mixing tends to occur because a portion of the upper surface of the infrared-transmissive layers 41, which is adjacent to the side surface, is covered. Furthermore, in the image sensor 100C shown in Fig. 10, because the tapered side surface of the infrared-blocking layer 6 is disposed inside the pixels containing the first colored layers 42, stray light tends to occur.

### <Modifications>

Fig. 7 is a cross-sectional view showing a portion of an image sensor according to a modification of the image sensor 1A. The image sensor 1B shown in Fig. 7 is the same as the image sensor 1A shown in Figs. 1 and 2, except in that the first colored layers 42 have a reverse tapered cross-sectional shape. As a result of the first colored layers 42 having a reverse tapered cross-sectional shape, the infrared-transmissive layers 41 are less likely to become detached, due to an anchoring effect. A colored layer having a reverse tapered cross-sectional shape can be obtained, for example, by appropriately combining known techniques such as adding an appropriate amount of an additive, such as an ultraviolet radiation absorber, to the photosensitive material that forms the colored layer.

### [Examples]

Hereinafter, test examples carried out in relation to the present invention will be described.

### (Example 1)

A portion of the structure included in the image sensor 1A shown in Fig. 6 (hereinafter referred to as a "partial structure" or a "partial structure of the image sensor") was manufactured by the method described below.

### · First step

First, three types of photosensitive materials containing different pigments were prepared. Using these, first colored layers 42, second colored layers 43, and third colored layers 44 were patterned on the substrate 2 by a photolithography method including exposure, development and sintering to form the color filter 4 (see Fig. 3). Here, the first colored layers 42, the second colored layers 43, and the third colored layers 44 were a red layer, a green layer, and a blue layer. respectively. The film thickness of each colored layer was 0.5 µm.

### · Second step

Then, the color filter 4 and the section of the upper surface of the substrate that was not covered with the color filter 4 was coated with a photosensitive material containing an infrared radiation transmissive colorant, a polymerizable compound, a binder resin, and a photopolymerization initiator to form a coating film. Here, a mixed colorant consisting of a red organic pigment, a green organic pigment, and a blue organic pigment was used as the infrared radiation transmissive colorant.

Next, the infrared-transmissive layers 41 having the first through-holes T embedded therein, and formed protruding from the first through-holes T were formed by patterning the coating film using a photolithography method including exposure, development, and sintering (see Fig. 4). The film thickness of the obtained infrared-transmissive layers 41 was 1.5 µm. Here, the film thickness of the infrared-transmissive layers 41 refers to the maximum height H_{PH} shown in Fig. 2.

### · Third step

Then, the photosensitive material containing the infrared absorbing colorant, the polymerizable compound, the acrylic resin, and the photopolymerization initiator was applied to the color filter 4 to form a coating film such that height of the upper surface was less than that of the infrared-transmissive layers 41. Here, a squarylium dye was used as the infrared absorbing colorant. Next, the infrared-blocking layer 6 was formed by patterning the coating film using a photolithography method including exposure and development (see Fig. 5).

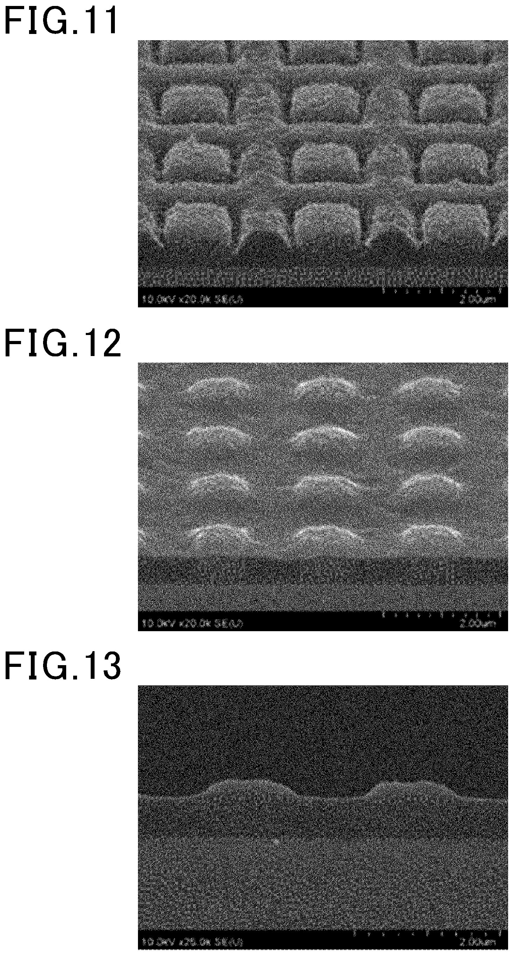

Fig. 11 is an electron micrograph in which a partial structure including the infrared-blocking layer 6 obtained in the third step after exposure and development has been captured from an oblique direction before application of a heat flow.

### · Fourth step

Next, the infrared-blocking layer 6 obtained in the third step was subjected to a heat flow by sintering. As a result, a partial structure of the image sensor 1A, in which the micro lens array 5 had been omitted from the image sensor 1A, was manufactured. The film thickness of the infrared-blocking layer 6 was 0.7 µm, and the difference H_{D} between the height of the upper surface of the infrared-transmissive layers 41 and the height of the upper surface of the infrared-blocking layer 6 (H_{D} = H_{PH} - H_{CL}) was 0.3 µm. Here, the film thickness of the infrared-blocking layer 6 refers to a film thickness obtained by subtracting the film thickness of the color filter 4 from the minimum height H_{CL} shown in Fig. 2.

Fig. 12 is an electron micrograph in which a partial structure including the infrared-blocking layer 6 obtained in the fourth step has been captured from an oblique direction after application of a heat flow, and Fig. 13 is an electron micrograph in which a cross-section of the partial structure has been captured. From a comparison with Fig. 11, it was confirmed that, by applying a heat flow to the infrared-blocking layer 6, the gaps between the infrared-blocking layer 6 and the infrared-transmissive layers 41 were eliminated. On the other hand, because the upper surface of the infrared-transmissive layers 41 was higher than the upper surface of the infrared-blocking layer 6, it was confirmed that the upper surface of the infrared-blocking layer 6 was not covered by the infrared-blocking layer 6 that had been subjected to a heat flow. Therefore, it can be understood that the image sensor 1A obtained by the manufacturing method of Example 1 suppresses the occurrence of color mixing and stray light.

### (Comparative Example 1)

### · First step

The color filter 4 was formed on the substrate 2 using the same method as the first step in Example 1 (see Fig. 3). The film thickness of each colored layer was 0.5 µm.

### · Second step

Then, the infrared-transmissive layers 41 were formed by the same method as the second step of Example 1, except for changing the application amount of the photosensitive material to the color filter 4 and the section of the upper surface of the substrate 2 that was not covered with the color filter 4 (see Fig. 4). The film thickness of the obtained infrared-transmissive layers 41 was 1.0 µm.

### · Third step

Next, a coating film was formed by applying the same photosensitive material as the photosensitive material used in the third step of Example 1 to the infrared-transmissive layers 41 and the color filter 4. Then, the infrared-blocking layer 6 in which the height of the upper surface was greater than that of the infrared-transmissive layers 41 was formed on the color filter 4 by patterning the coating film using a photolithography method including exposure and development (see Fig. 9).

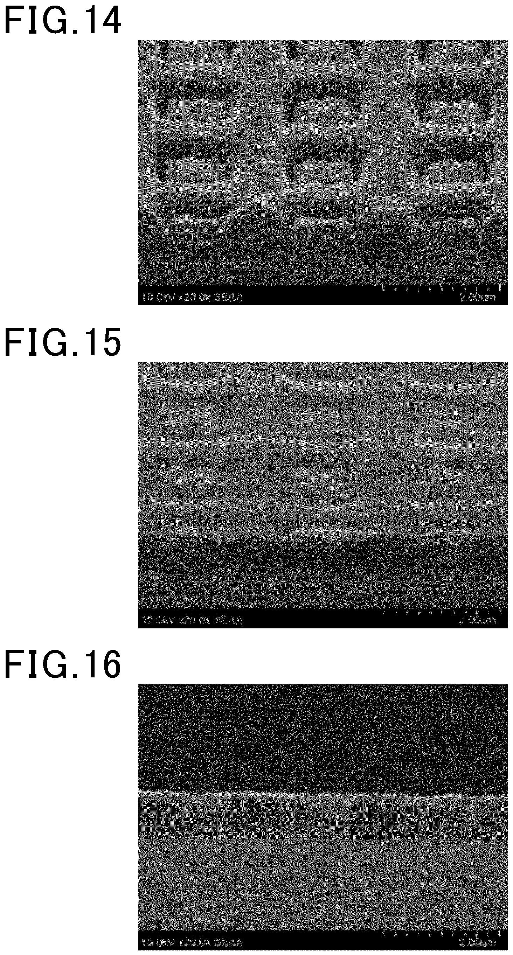

Fig. 14 is an electron micrograph in which a partial structure of an image sensor according to a comparative example including the infrared-blocking layer 6 obtained in the third step after exposure and development has been captured from an oblique direction before application of a heat flow.

### · Fourth step

Next, the infrared-blocking layer 6 obtained in the third step was subjected to a heat flow by sintering. As a result, a partial structure of the image sensor, in which the micro lens array 5 had been omitted from the image sensor 100B shown in Fig. 9, was manufactured. In the partial structure obtained here, the film thickness of the infrared-blocking layer 6 was 0.7 µm, and the difference H_{D} between the height of the upper surface of the infrared-transmissive layers 41 and the height of the upper surface of the infrared-blocking layer 6 (H_{D} = H_{PH} - H_{CL}) was -0.2 µm.

Fig. 15 is an electron micrograph in which a partial structure of an image sensor including the infrared-blocking layer 6 obtained in the fourth step has been captured from an oblique direction after application of a heat flow, and Fig. 16 is an electron micrograph in which a cross-section of the partial structure has been captured. From a comparison with Fig. 14, it was confirmed that, by applying a heat flow to the infrared-blocking layer 6, the outer peripheral portion of the upper surface of the infrared-transmissive layers 41 was covered with the infrared-blocking layer 6. It is presumed that color mixing tends to occur more easily in an image sensor manufactured using such a method.

The present invention is not limited to the embodiments described above, but may be modified in various ways when implemented, without departing from the spirit of the present invention. Furthermore, the embodiments may be appropriately combined when implemented, and in this case, a combination of the advantageous effects is obtained. The embodiments described above include various inventions, and various inventions can be extracted from combinations selected from a plurality of disclosed constituent elements. For example, even if some constituent elements are omitted from all the constituent elements disclosed in the embodiments, configurations with these constituent elements omitted can be interpreted to be within the scope of the invention as long as the problems can be solved and the advantageous effects can be obtained.

### [Reference Signs List]

- 1A: Image sensor
- 1B: Image sensor
- 2: Substrate
- 4: Color filter
- 5: Micro lens array
- 6: Infrared-blocking layer
- 21: Photodiode
- 41: Infrared-transmissive layer
- 42: First colored layer
- 43: Second colored layer
- 44: Third colored layer
- 51: Micro lens
- 100A: Image sensor
- 100B: Image sensor
- 100C: Image sensor
- D: First through-hole

## Claims

1. An image sensor comprising:
a substrate on which a plurality of photodiodes are provided;
a color filter including a plurality of colored layers which are each provided on a portion of the plurality of photodiodes, and a plurality of first through-holes which are each provided in a position of another portion of the plurality of photodiodes;
an infrared-blocking layer which is provided on the color filter, blocks infrared radiation having a specific wavelength, and transmits visible light, and has a plurality of second through-holes each communicating with the plurality of first through-holes;
a plurality of infrared-transmissive layers, in each of which one of the plurality of first through-holes and the second through-hole communicating therewith are embedded, and which block visible light and transmit the infrared radiation having the specific wavelength; and
a plurality of micro lenses each facing the plurality of photodiodes and having the color filter, the infrared-blocking layer, and the plurality of infrared-transmissive layers interposed therebetween; wherein
a side wall of each of the plurality of second through-holes is entirely in contact with a side surface of any one of the plurality of infrared-transmissive layers;
an upper surface of the infrared-blocking layer has a maximum height H_{CH} at a position of a boundary with the plurality of infrared-transmissive layers, and has a minimum height H_{CL} at a position away from the boundary, and
an upper surface of each of the plurality of infrared-transmissive layers has a maximum height H_{PH} that is greater than the minimum height H_{CL} and is greater than or equal to the maximum height H_{CH}.

2. The image sensor according to claim 1, wherein
the upper surface of each of the plurality of infrared-transmissive layers has a convex shape.

3. The image sensor according to claim 1, wherein
of the upper surface of the infrared-blocking layer, a plurality of first regions that are each adjacent to the plurality of second through-holes have a height that is greater than that of second regions, which are each adjacent to the plurality of second through-holes and have the plurality of first regions interposed therebetween.

4. The image sensor according to claim 1, wherein
one or more of the plurality of colored layers that are in contact with the plurality of infrared-transmissive layers has a reverse tapered cross-sectional shape.

5. A method for manufacturing an image sensor, the method comprising:
forming a color filter including a plurality of colored layers and having a plurality of through-holes, such that each of the plurality of colored layers is provided on a portion of a plurality of photodiodes that are provided on a substrate, and the plurality of through-holes are provided in a position of another portion of the photodiodes;
forming a plurality of infrared-transmissive layers that block visible light and transmit infrared radiation having a specific wavelength, each having one of the plurality through-holes embedded therein, and formed protruding from the plurality of through-holes;
forming, on the color filter, an infrared-blocking layer that blocks infrared radiation having the specific wavelength, and transmits visible light, such that an upper surface of the infrared-blocking layer has a height that is less than that of the plurality of infrared-transmissive layers;
subjecting the infrared-blocking layer to a heat flow; and
forming thereafter a plurality of micro lenses each facing the plurality of photodiodes and having the color filter, the infrared-blocking layer, and the plurality of infrared-transmissive layers interposed therebetween.
